(19) Europäisches Patentamt

European Patent Office

Office européen des brevets

(11) **EP 1 335 248 A1**

(12) **EUROPEAN PATENT APPLICATION**

(43) Date of publication:
**13.08.2003 Bulletin 2003/33**

(51) Int Cl.⁷: **G03F 7/20**

(21) Application number: **03250815.2**

(22) Date of filing: **10.02.2003**

| | |
|---|---|
| (84) Designated Contracting States: **AT BE BG CH CY CZ DE DK EE ES FI FR GB GR HU IE IT LI LU MC NL PT SE SI SK TR** Designated Extension States: **AL LT LV MK RO** | (72) Inventor: **De Jongh, Robertus Johannes Marinus 5615 NM Eindhoven (NL)** |
| (30) Priority: **12.02.2002 EP 02250966** | (74) Representative: **Leeming, John Gerard J.A. Kemp & Co., 14 South Square, Gray's Inn London WC1R 5JJ (GB)** |
| (71) Applicant: **ASML Netherlands B.V. 5503 LA Veldhoven (NL)** | |

(54) **Lithographic apparatus and device manufacturing method**

(57)    Modified control of a moveable component (MT, MA;WT, W) within the apparatus to provide improved control of the position and velocity of a point ($C_s$) on the component that is set apart from the center of mass of the component. The force required to provide the center of mass of the component with the acceleration required for the point on the component is determined. The force in a given direction.is corrected by an amount proportional to the product of the velocity of the point in an orthogonal direction and the angular velocity about an axis perpendicular to the two orthogonal directions.

Fig. 3

EP 1 335 248 A1

**Description**

The present invention relates to a device manufacturing method comprising the steps of:

- providing a substrate that is at least partially covered by a layer of radiation-sensitive material;
- providing a projection beam of radiation using a radiation system;
- using patterning means to endow the projection beam with a pattern in its cross-section;
- projecting the patterned beam of radiation onto a target portion of the layer of radiation-sensitive material.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array, One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus — commonly referred to as a step-and-scan apparatus — each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

The position and movement of a variety of moveable components within a lithographic apparatus must be accurately controlled. In many cases movement and control may be required in six degrees of freedom (linearly in three orthogonal directions and rotationally about three orthogonal axes). In a step-and-scan apparatus for example, the mask table and the substrate table must be scanned, e.g. in the y direction, underneath the projection beam and the projection system, respectively. At each instant the position and velocity of the mask table and the substrate table must be accurately controlled. For example, it is vital that the mask table's position within the plane of the mask (in an X-Y plane substantially perpendicular to the projection beam) is accurate to prevent, for example, overlay errors. It is also important that the position of the mask table in the Z direction (parallel to the projection beam) is accurate to ensure that the image is correctly focused. Any rotations of the mask table, either about an axis parallel to the projection beam or about an axis in the plane of the mask will also produce imaging errors.

To effect the control required for the mask table or the substrate it is provided with an actuator system capable of providing controlled linear forces, acting in straight lines, in at least two mutually perpendicular directions and a torque force about an axis perpendicular to the direction of the two linear forces. Preferably the actuator system is capable of providing linear forces in three mutually perpendicular directions and torque forces about axes parallel to these directions. The forces linearly and rotationally accelerate the mask pattern or the substrate, as required, and therefore, using an appropriate controller it is possible to control the position and velocity of the object in six degrees of freedom. The actuator system may, for example, be comprised of a plurality of individual actuators combined with a gravity compensator to bear the weight of the mask table or substrate table. Alternatively, the actuator system may be a planar motor (for an explanation of planar motors, see, for example, WO 01/18944 A1 which is incorporated herein by reference) which provides all of the forces required to control the substrate or mask table.

Conventional control systems only control the position and velocity of the substrate table or mask table as a whole. Therefore the position and velocity of a point on the component may not be controlled as precisely as required.

It is an object of the present invention to provide a method of controlling a moveable component within a lithographic apparatus that compensates for the effect of rotational adjustments of the component on the linear position and velocity of a point on the component.

This and other objects are achieved according to the invention in a device manufacturing method as specified in the opening paragraph, further comprising the steps of:

- effecting desired linear accelerations in first and second orthogonal directions and an angular acceleration about an axis perpendicular to said first and second directions on a point on a component;

wherein said step of effecting said desired linear and angular accelerations comprises the steps of:

- determining the positioning forces required to effect said desired accelerations on the center of mass of said component;
- determining a corrective force, said corrective force being in said second direction and having a magnitude proportional to the velocity in the first direction of said point on said component and the angular velocity of said component about said axis perpendicular to the first and second directions; and

- applying the sum of the positioning forces and the corrective force to the center of mass of the component.

Determining and applying the corrective force improves the control of the position and velocity of the region within the component by offsetting the effect on the point of interest, in the second direction, of the combination of the linear movement in the first direction and rotational movement, about the axis perpendicular to the first and second directions, of the element as a whole. Without this compensation, the linear position and velocity of points on the component are altered when the component is rotated, reducing the accuracy of the position and velocity control of those regions of the component. This can be severely detrimental if, for example, the point on the component is the area on the patterning means or the substrate on which the projection beam or the patterned beam, respectively, impinge. The present invention is therefore extremely beneficial since it allows greater positional accuracy of the area of interest within a component.

Preferably the force provided in the second direction is modified by two further corrective forces. The first is proportional to the product of the angular acceleration of said component about the axis perpendicular to the first and second directions and the distance in the first direction between the center of mass of the component and said point on the component; the second is proportional to the product of the acceleration of said component in the first direction and the angular displacement of the component about the axis perpendicular to the first and second directions relative to a predetermined position.

These corrective forces further improve the accuracy with which the position and velocity of the point on the component can be controlled in comparison with merely controlling the position and velocity of the component as a whole, namely controlling the position and velocity of the center of mass of the component.

The present invention can be used to control the position and velocity of the mask table holding the patterning means and/or the substrate table holding the substrate. This is especially useful since in both cases the projection beam (or patterned beam) only impinges on a relatively small targeting region of the patterning means (or substrate). It is therefore important to be able to accurately control, in six degrees of freedom, the position and velocity of the targeting region rather than merely the patterning means (or substrate) as a whole.

According to a further aspect of the invention there is provided a computer program for controlling a lithographic projection apparatus, said computer program comprising:

- code means for effecting desired linear accelerations in first and second orthogonal directions and an angular acceleration about an axis perpendicular to said first and second directions on a point on a component;

wherein said code means for effecting said desired linear and angular accelerations comprises code means for:

- determining the positioning forces required to effect said desired accelerations on the center of mass of said component;
- determining a corrective force, said corrective force being in said second direction and having a magnitude proportional to the velocity in the first direction of said point on said component and the angular velocity of said component about said axis perpendicular to the first and second directions; and
- controlling a system of actuators to apply the sum of the positioning forces and the corrective force to the center of mass of the component.

According to a yet further aspect of the present invention there is provided a lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a control system for determining the required forces to effect required linear accelerations in first and second orthogonal directions and a required angular acceleration about an axis perpendicular to the first and second directions on a point on a moveable component within the apparatus; wherein said control system comprises:

- means for determining the positioning forces required to effect said desired accelerations on the center of mass of said component;
- means for determining a corrective force, said corrective force being in said second direction and having a magnitude proportional to the velocity in the first direction of said point on said component and the angular velocity of said component about said axis perpendicular to the first and second directions;

- means for determining the sum of the positioning force and the corrective force;

- an actuator system for applying said sum of forces to the center of mass of said component.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:

Figure 1 depicts a lithographic projection apparatus according to an embodiment of the invention;
Figure 2 depicts a substrate being scanned while being exposed with a projection beam; and
Figure 3 depicts a substrate on a substrate table.

In the Figures, corresponding reference symbols indicate corresponding parts.

Embodiment 1

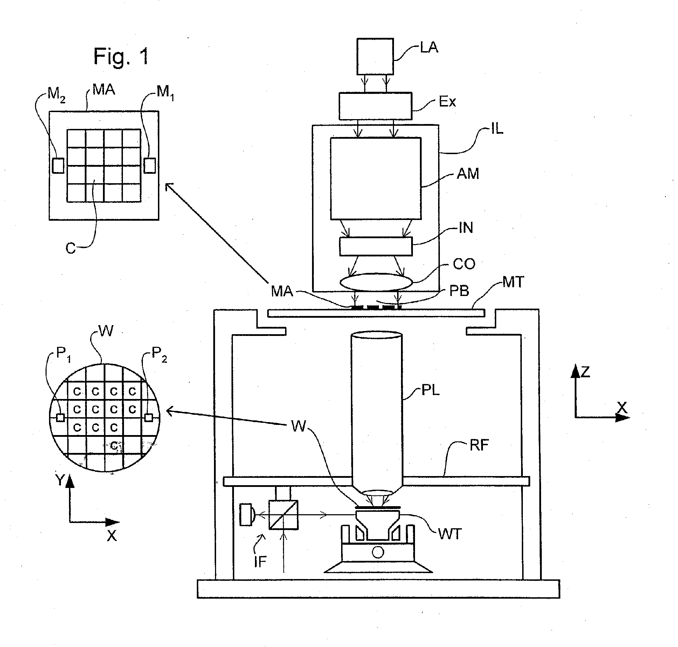

Figure 1 schematically depicts a lithographic projection apparatus according to a particular embodiment of the invention. The apparatus comprises:

a radiation system Ex, IL, for supplying a projection beam PB of radiation *(e.g.* UV radiation), which in this particular case also comprises a radiation source LA;
a first object table (mask table) MT provided with a mask holder for holding a mask MA (*e.g.* a reticle), and connected to first positioning means for accurately positioning the mask with respect to item PL;
a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive lens group) for imaging an irradiated portion of the mask MA onto a target portion C (*e.g.* comprising one or more dies) of the substrate W.

As here depicted, the apparatus is of a transmissive type (*i.e.* has a transmissive mask). However, in general, it may also be of a reflective type, for example (with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:

1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", *e.g.* the y direction) with a speed v, so that the projection beam PB is caused to scan over a mask image; concurrently, the substrate table WT is simultaneously moved in the same or opposite direction at a speed $V = Mv$, in which $M$ is the magnification of the lens PL (typically, $M = 1/4$ or $1/5$). In this manner, a relatively large target portion C can be exposed, without having to compromise on resolution.

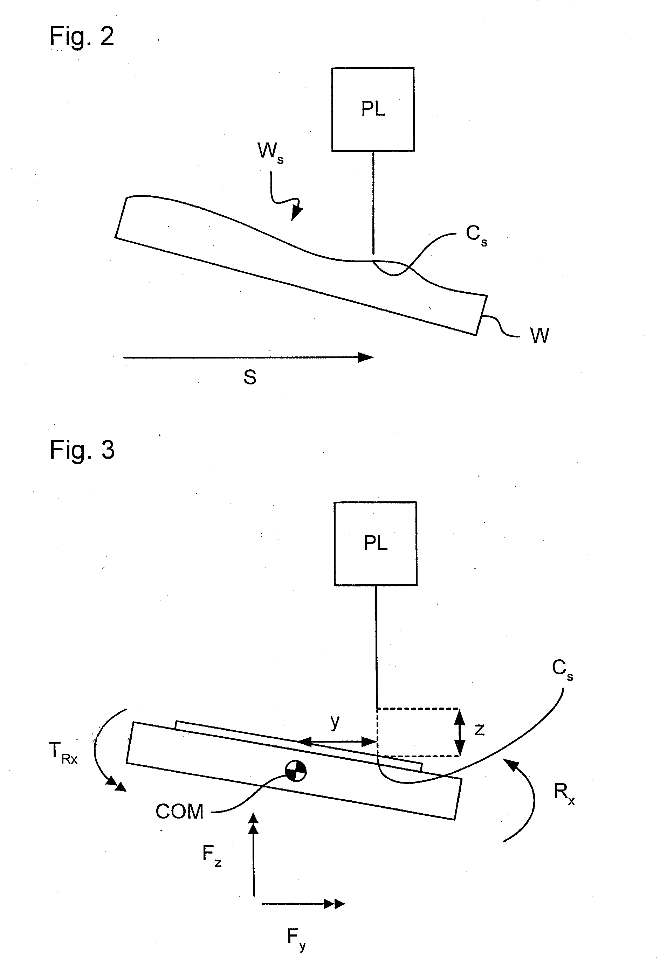

As described above and shown in Figure 2, when the apparatus is used in scan mode the projection beam is focused on a point on the substrate: a subsection of the target portion C of the substrate, referred to hereafter as the targeting region $C_S$ (correspondingly the projection beam is only focused on a targeting region $C_m$ of the target portion of the mask). This means that as the substrate is scanned (in the direction S, shown in Figure 2) the position and orientation of the substrate can be adjusted to take account of the imperfections of the substrate surface. For convenience in the following description, the scanning direction will be referred to as the Y direction, the direction parallel to the beam of radiation will be referred to as the Z direction and the direction perpendicular to the plane of Figure 2 (i.e. perpendicular to both the Y and Z direction) will be referred to as the X direction.

The imperfections in the substrate surface $W_S$ shown in Figure 2 are an exaggeration but, in general, it may be desirable to rotate the substrate about the X axis such that the surface of the targeting region $C_S$ of the substrate is substantially perpendicular to the projection beam. It may also be desirable to adjust the position of the substrate in the Z direction to ensure that targeting region $C_s$ is at substantially the correct focal length from the projection lens PL. Corresponding considerations apply when positioning the mask relative to the source LA. One should note that the targeting region $C_s$ on the substrate is not fixed with respect to the substrate. As the substrate is scanned underneath the projection beam, the targeting region $C_S$ moves along the surface of the substrate.

The determination of the surface topography (and hence the required adjustments) of the substrate table or mask table may be determined in advance of the scanning during a so-called "pre-scan stage" or it may be determined as the scan proceeds ("on the fly"). Although not shown in Figure 2, the position of the substrate table or mask table may also be adjusted by rotations about the Y axis and about the Z axis. Finally, corrections may also be required in the X direction.

Figure 3 depicts a substrate W on a substrate table WT and some coordinates that may be used to define the position, velocity and acceleration of the substrate table as well as the forces applied to the substrate table. The substrate table is supported by air mounts or a planar motor. Consequently any torque $T_{Rx}$ applied to the substrate table about the X axis will cause it to accelerate about the center of mass COM of the combination of the substrate table and the substrate. The resulting change in the angular position $R_x$ of the substrate table will cause an error in the position z of point $C_s$ in the Z direction. Therefore adjustments must be made to the force $F_z$ in the Z direction when a torque $T_{Rx}$ is applied to the substrate table.

The angular acceleration of an object, in this case the combination of the substrate table and the substrate, is proportional to the torque applied to it. In this case this can be represented as

$$T_{Rx} = J_{xx} \cdot \ddot{R}_x \qquad (1)$$

where $J_{xx}$ is the moment of inertia of the combination of the substrate table and the substrate about the X axis and $\ddot{R}_x$ is the angular acceleration.

This angular acceleration $\ddot{R}_x$ causes linear accelerations of regions within the substrate and substrate table. In the present case we are interested in the effect of the linear acceleration, in the Z direction, of the targeting region $C_S$ of the substrate on which the projection beam is targeted. As discussed above, the distance z between the targeting region $C_S$ on the substrate and the projection system must remain constant to maintain the focus of the image on the substrate. The linear acceleration $\ddot{z}_1$ in the Z direction of the targeting region $C_S$ of the substrate resulting from the angular acceleration may be determined by

$$\ddot{Z}_1 = y \cdot \ddot{R}_x \qquad (2)$$

where y is the distance between the center of mass COM of the combination of the substrate table and the substrate and the targeting region $C_S$ of the substrate in the Y direction.

Furthermore, the combined effect of the linear velocity $\dot{y}$ in the Y direction (the scanning direction) of the targeting region $C_S$ of the substrate and the angular velocity $\dot{R}_x$ of the substrate about the X axis produces an additional acceleration $\ddot{z}_2$ of the targeting region $C_S$ in the Z direction. The linear velocity $\dot{y}$ of the targeting region $C_S$ is not determined directly. The interferometric system determines the position and velocity of the substrate as a whole. The position and velocity of the targeting region $C_S$ can be determined from these measurements by a simple mathematical relationship. The acceleration $\ddot{z}_2$ may be determined by the following equation.

$$\ddot{Z}_2 = \dot{y} \cdot \dot{R}_x \qquad (3)$$

Finally, the acceleration of the substrate table and substrate in Y direction (largely at the beginning and end of scans) may also result in an acceleration of the targeting region $C_S$ in the Z direction. This acceleration effect may be determined by the following equation.

$$\ddot{Z}_3 = \ddot{y} \cdot R_x \qquad (4)$$

Therefore, in order to accurately control the position of the targeting region $C_S$ of the substrate, forces in the Z direction must be applied to the substrate to offset the accelerations $\ddot{z}_1$, $\ddot{z}_2$ and $\ddot{z}_3$ created by the movement of the substrate. These forces are in addition to the force required to provide the acceleration $\ddot{z}_s$ required to adjust the position of the substrate as a whole. The total force $F_Z$ that must be applied to the substrate in the Z direction may be determined by

$$F_z = m \cdot \left( \ddot{Z}_S + \ddot{Z}_1 + \ddot{Z}_2 + \ddot{Z}_3 \right) \qquad (5)$$

where m is the combined mass of the substrate table and the substrate.

Depending on the conditions in which the apparatus is operating, some of the terms in the above expression may be negligible and may therefore be dropped to simplify the control system. The forces required to correct the $\ddot{z}_1$, $\ddot{z}_2$ and $\ddot{z}_3$ accelerations may be provided by separate actuators however, more conveniently, a single actuator may be used to provide the total force $F_Z$, a control system being used to determine the total force required. Preferably the forces are provided by a planar motor which can provide all of the forces required to control the substrate table in six degrees of freedom.

It will be apparent that the same method and apparatus with suitable modifications may be used to adjust the position of a component in the Z direction as a result of linear movement in the X direction and rotational movement about the Y axis. Correspondingly, the method and apparatus may also be used to adjust the position of the component in the Y direction and in the X direction to compensate for motions along and about the other two axes.

Whilst specific embodiments of the invention have been described above, it will be appreciated that the invention may be practiced otherwise than as described. The description is not intended to limit the invention. Specifically, whilst the above description has referred to the control of the substrate table and the mask table, it should be appreciated that the invention may be applied to the positioning of any moveable component within the apparatus.

**Claims**

1. A device manufacturing method comprising the steps of:

   - providing a substrate that is at least partially covered by a layer of radiation-sensitive material;
   - providing a projection beam of radiation using a radiation system;
   - using patterning means to endow the projection beam with a pattern in its cross-section;
   - projecting the patterned beam of radiation onto a target portion of the layer of radiation-sensitive material; and
   - effecting desired linear accelerations in first and second orthogonal directions and an angular acceleration about an axis perpendicular to said first and second directions on a point on a component;

   wherein said step of effecting said desired linear and angular accelerations comprises the steps of:

   - determining the positioning forces required to effect said desired accelerations on the center of mass of said component;
   - determining a corrective force, said corrective force being in said second direction and having a magnitude proportional to the velocity in the first direction of said point on said component and the angular velocity of said component about said axis perpendicular to the first and second directions; and
   - applying the sum of the positioning forces and the corrective force to the center of mass of the component.

2. A device manufacturing method according to claim 1, wherein the step of applying the sum of the positional forces and the corrective force uses a system of actuators, not all of which act through the center of mass, and wherein the forces applied by the system of actuators are such that their sum at the center of mass of said component are equal to said sum of the positional forces and the corrective force.

3. A device manufacturing method according to claim 1 or 2, further comprising the step of determining a second corrective force, said second corrective force in said second direction with a magnitude proportional to the product of the angular acceleration of said component about said axis perpendicular to said first and second directions and the distance in the first direction between the center of mass of the component and said point on the component; and wherein said applying step applies the sum of the positioning and corrective forces.

4. A device manufacturing method according to claim 1, 2 or 3, further comprising the step of determining a third corrective force, said third corrective force in said second direction with a magnitude proportional to the product of the acceleration of said component in the first direction and the angular displacement of said component, about said axis perpendicular to the first and second directions, relative to a predetermined position; and wherein said applying step applies the sum of the positioning and corrective forces.

5. A device manufacturing method according to any preceding claim, wherein said component is the combination of the patterning means and its support and said point on said component is the area on the patterning means on which the projection beam is incident.

6. A device manufacturing method according to any one of claims 1 to 4, wherein said component is the combination of the substrate and a substrate table supporting it and said point on said component is the area on the substrate on which the patterned beam is incident.

7. A device manufacturing method according to claim 5 or 6, wherein the second direction is parallel to the direction of the projection beam or the patterned beam.

8. A computer program for controlling a lithographic projection apparatus, said computer program comprising:

   - code means for effecting desired linear accelerations in first and second orthogonal directions and an angular acceleration about an axis perpendicular to said first and second directions on a point on a component;

   wherein said code means for effecting said desired linear and angular accelerations comprises code means for:

   - determining the positioning forces required to effect said desired accelerations on the center of mass of said component;
   - determining a corrective force, said corrective force being in said second direction and having a magnitude proportional to the velocity in the first direction of said point on said component and the angular velocity of said component about said axis perpendicular to the first and second directions; and

- controlling an actuator system to apply the sum of the positioning forces and the corrective force to the center of mass of the component.

9. A lithographic projection apparatus comprising:

- a radiation system for providing a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a control system for determining the required forces to effect required linear accelerations in first and second orthogonal directions and a required angular acceleration about an axis perpendicular to the first and second directions on a point on a moveable component within the apparatus; wherein said control system comprises:

  - means for determining the positioning forces required to effect said desired accelerations on the center of mass of said component;
  - means for determining a corrective force, said corrective force being in said second direction and having a magnitude proportional to the velocity in the first direction of said point on said component and the angular velocity of said component about said axis perpendicular to the first and second directions;
  - means for determining the sum of the positioning force and the corrective force;

- an actuator system for applying said sum of forces to the center of mass of said component.

10. A lithographic projection apparatus according to claim 9, wherein said actuator system is a planar motor.

Fig. 1

Fig. 2

Fig. 3

**European Patent Office**

**EUROPEAN SEARCH REPORT**

Application Number

EP 03 25 0815

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | US 2001/002303 A1 (YUAN BAUSAN) 31 May 2001 (2001-05-31) * paragraph '0019! - paragraph '0061! * --- | 1,8,9 | G03F7/20 |
| A | EP 0 848 299 A (NIPPON KOGAKU KK) 17 June 1998 (1998-06-17) * column 2, line 36 - line 50 * * column 10, line 9 - column 13, line 53 * --- | 1,8,9 | |
| A | EP 0 833 208 A (NIPPON KOGAKU KK) 1 April 1998 (1998-04-01) * page 4, line 39 - page 5, line 9 * * figure 13 * * page 8, line 7 - page 11, line 51 * --- | 1,8,9 | |
| A | US 5 461 237 A (IMAI YUJI ET AL) 24 October 1995 (1995-10-24) * column 10, line 19 - column 12, line 44 * ----- | 1,8,9 | |

| | TECHNICAL FIELDS SEARCHED (Int.Cl.7) |
|---|---|
| | G03F |

The present search report has been drawn up for all claims

| Place of search | Date of completion of the search | Examiner |
|---|---|---|
| THE HAGUE | 31 March 2003 | Aguilar, M. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 03 25 0815

This annex lists the patent family members relating to the patent documents cited in the above-mentioned European search report.
The members are as contained in the European Patent Office EDP file on
The European Patent Office is in no way liable for these particulars which are merely given for the purpose of information.

31-03-2003

| Patent document cited in search report | | Publication date | Patent family member(s) | | Publication date |
|---|---|---|---|---|---|
| US 2001002303 | A1 | 31-05-2001 | NONE | | |
| EP 0848299 | A | 17-06-1998 | JP | 10177950 A | 30-06-1998 |
| | | | EP | 0848299 A2 | 17-06-1998 |
| | | | US | 6411387 B1 | 25-06-2002 |
| EP 0833208 | A | 01-04-1998 | JP | 10070065 A | 10-03-1998 |
| | | | JP | 10074687 A | 17-03-1998 |
| | | | EP | 0833208 A2 | 01-04-1998 |
| | | | US | 6172373 B1 | 09-01-2001 |
| US 5461237 | A | 24-10-1995 | JP | 3381313 B2 | 24-02-2003 |
| | | | JP | 6097046 A | 08-04-1994 |

EPO FORM P0459

For more details about this annex : see Official Journal of the European Patent Office, No. 12/82